# EUROPEAN PATENT APPLICATION

(11) **EP 4 388 917 A1**
(43) Date of publication of application: **26.06.2024**
(21) Application number: 23215669.5
(22) Date of filing: 11.12.2023
(51) Int. Cl.: A44C 5/00, G07C 9/00, H04B 1/034, H05K 1/18, G04G 21/04

(54) **A STRAP COMPRISING A PRINTED CIRCUIT BOARD**

(30) Priority: 22.12.2022 GB 202219506; 27.04.2023 GB 202306207
(71) Applicant: Armour Surveillance Security Equipment and Technology Ltd, London W1J 6EE (GB)
(72) Inventor: FAWCETT, Patrick James, London, W1J 6EE (GB); DINAN, Richard, London, W1J 6EE (GB)
(74) Representative: HGF

(57) **Abstract**

Herein disclosed is a method of manufacturing a strap comprising providing a mould for a strap, the strap comprising a first opening and a second opening, providing a printed circuit board (PCB), comprising at least one electronic component, applying a membrane to said electronic component, attaching a chassis to said PCB at said electronic component such that said membrane is sealed against said electronic component; injecting a wet applied structural component into said mould.

## Description

### TECHNICAL FIELD

The invention relates to a method of manufacturing a strap for a wearable device, the method involving applying a membrane to an electronic component.

### BACKGROUND

Portable electronic devices, such as watches and straps with a radio transmitter, require a substantial number of components to be located into a relatively small volume, particularly if the resulting electronic device is to be small enough to be worn on the wrist for everyday use. There are many design limitations for such straps, such as requiring the use of radio transparent materials, being soft enough for comfort, being flexible enough to be accommodated on the wrist, whilst being sturdy enough to protect the delicate electronic components.

A common issue with such watches and straps is that the internal components can be seen deforming and protruding from the strap, such as when the strap is bent. This can cause discomfort for the user and ruin the aesthetic appeal of the strap, as well as destroying any environmental seal provided by the strap. Making the strap out of harder materials could overcome this issue but this necessarily makes the strap less comfortable and decreases flexibility.

### BRIEF SUMMARY

A first aspect of the present invention relates to a method of manufacturing a strap comprising: providing a mould for a strap, the mould comprising a first opening and a second opening, providing a printed circuit board (PCB) comprising at least one electronic component, applying a membrane to said electronic component, attaching a chassis to said PCB at said electronic component such that said membrane is urged towards said electronic component; injecting a wet applied structural component into said mould.

By providing a membrane around the electronic component and urging the membrane towards the electronic component a fluid tight seal is created. It is important that the PCB is potted by the wet applied structural component to provide a water and dirt proof seal, however some components of the strap must not be potted, for example a button which is depressible from the exterior of the strap. If the wet applied structural component were to seal the button, it would become inoperable, or require an additional machining step during manufacture in order to work. By providing the membrane over the electronic component and using the chassis to compress the membrane, wet applied structural component is prevented from entering the relevant volume, whilst also providing a water and dirt proof seal for the electronic component.

According to an example, the electronic component comprises a plurality of blind holes, and wherein the method further comprises soldering pins to said blind holes.

By using blind holes rather than through holes, the likelihood of causing a short circuit by contact between the soldering pins and the electrified portions of the electronic component is minimised.

According to an example, said chassis comprises pin holes and the chassis is attached to said PCB by inserting said pins into said pin holes, applying a force to the chassis to compress said membrane and attaching the pins to the chassis.

According to an example, the pins are attached to the chassis by soldering.

According to an example, the chassis is attached to said electronic component by a band under tension.

According to an example, the thickness of the strap is less than 10 millimetres.

According to an example, the strap comprises polyurethane.

According to an example, the membrane is formed of silicone.

According to an example, the membrane is transparent for light in the visible spectrum.

According to an example, a further electronic component is attached to said chassis, the further electronic component comprising a button.

According to an example, the further electronic component comprises an LED indicator.

According to an example, the strap comprises at least one of a battery and a transmitter for transmitting radio signals, which is in electrical communication with said electronic component and/ or said further electronic component.

According to an example, the mould comprises silicone.

According to an example, the first component is arrested by a tool, inserted into said mould.

According to an example, the mould comprises vents, said vents in fluid communication with a vacuum generator for lowering the air pressure within said mould.

According to an example, the strap is attachable to a watch housing.

According to an example, the membrane comprises holes coincident said pins.

A further aspect of the present invention relates to a wearable device made according to the method above.

A further aspect of the present invention relates to a strap, comprising: a printed circuit board (PCB) on which is mounted electronic components including a transmitter for transmitting radio signals and a button in electrical communication with said transmitter, a chassis attached to said button, a depressible button interface mounted on said chassis, a membrane providing a waterproof seal for said button wherein when said depressible button interface is pressed, said waterproof seal deforms and actuates said button.

Straps for wearable devices must be formed of resilient material which is relatively difficult to deform. The present invention requires a button which can be depressed whilst also needing to be secure from water and dirt infiltration, the seal for the button must therefore be different to the material which forms the strap. By providing a membrane over the button which is in contact with the user actuatable depressible button on the exterior of the strap, a fluid tight seal is created which still allows the button to be pressed.

According to an example, the strap comprises at least one battery located within said strap and in electronic communication with said PCB.

According to an example, said battery is a coin cell.

According to an example, said strap comprises polyurethane.

According to an example, wherein the strap can be attached to a watch housing.

According to an example, said waterproof layer is formed of silicone.

According to an example, said chassis and said button compress said waterproof seal.

According to an example, said chassis is attached to said PCB by a plurality of pins.

### BRIEF DESCRIPTION OF THE SEVERAL VIEWS OF THE DRAWINGS

To easily identify the discussion of any particular element or act, the most significant digit or digits in a reference number refer to the figure number in which that element is first introduced.
FIG. 1A illustrates an aspect of the subject matter in accordance with one embodiment.
FIG. 1B illustrates an aspect of the subject matter in accordance with one embodiment.
FIG. 2 illustrates an aspect of the subject matter in accordance with one embodiment.
FIG. 3 illustrates an aspect of the subject matter in accordance with one embodiment.
FIG. 4 illustrates an aspect of the subject matter in accordance with one embodiment.
FIGs. 5A and 5B illustrate an aspect of the subject matter in accordance with one embodiment
FIGs. 6A and 6B illustrate an aspect of the subject matter in accordance with one embodiment.
FIG. 7 illustrates an aspect of the subject matter in accordance with one embodiment.

### DETAILED DESCRIPTION

Certain terminology is used in the following description for convenience only and is not limiting. The words 'right', 'left', 'lower', 'upper', 'front', 'rear', 'upward', 'down', 'downward', 'above' and 'below' designate directions in the drawings to which reference is made and are with respect to the described component when assembled and mounted (e.g. *in situ*)*.* The words `inner', `inwardly' and `outer', 'outwardly' refer to directions toward and away from, respectively, a designated centreline or a geometric centre of an element being described (e.g. central axis), the particular meaning being readily apparent from the context of the description.

Further, as used herein, the terms 'connected', 'attached', 'coupled', 'mounted' are intended to include direct connections between two members without any other members interposed therebetween, as well as, indirect connections between members in which one or more other members are interposed therebetween. The terminology includes the words specifically mentioned above, derivatives thereof, and words of similar import.

Further, unless otherwise specified, the use of ordinal adjectives, such as, 'first', 'second', 'third' etc. merely indicate that different instances of like objects are being referred to and are not intended to imply that the objects so described must be in a given sequence, either temporally, spatially, in ranking or in any other manner.

Through the description and claims of this specification, the terms 'comprise' and 'contain', and variations thereof, are interpreted to mean `including but not limited to', and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality, as well as, singularity, unless the context requires otherwise.

Features, integers, characteristics, compounds, chemical moieties or groups described in conjunction with a particular aspect, embodiment or example of the invention are to be understood to be applicable to any other aspect, embodiment or example described herein unless incompatible therewith. All of the features disclosed in this specification (including any accompanying claims, abstract and drawings), and/or all of the steps of any method or process so disclosed, may be combined in any combination, except combinations where at least some of such features and/or steps are mutually exclusive. The invention is not restricted to the details of any foregoing embodiments. The invention extends to any novel one, or any novel combination, of the features disclosed in this specification (including any accompanying claims, abstract or drawings), or to any novel one, or any novel combination, of the steps of any method or process so disclosed.

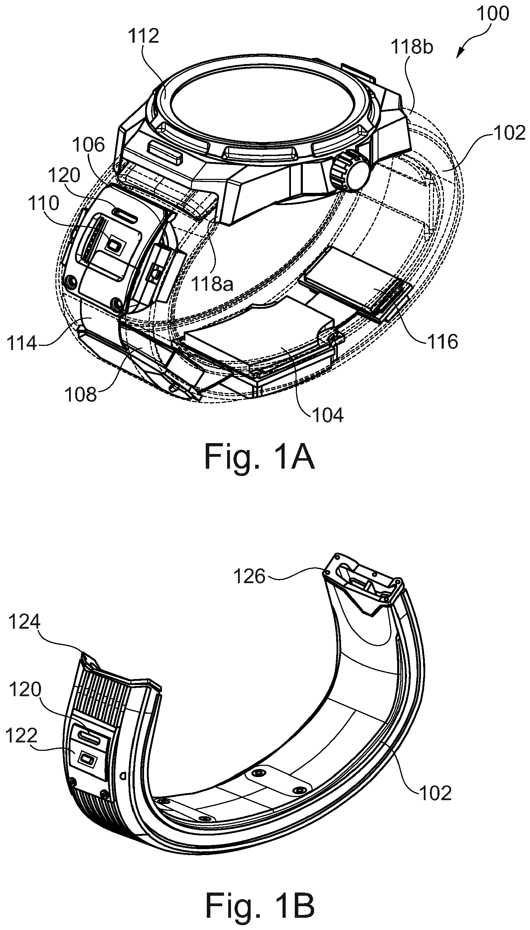

FIG. 1A shows the internal components of a strap 102 according to an embodiment of the present invention. The strap 102 is connectable to a watch housing 112 to provide the functionality of a conventional mechanical watch with apparatus for communicating with a remote security system. Although the present invention may have other applications, the invention will be described with particular reference to examples in which the security system is a remote security system of a vehicle, such as a keyless entry or a Keyless Go^{™} system. The strap may be a strap, or bracelet without a watch or watch housing 112.

The strap 100, includes two ends 118a, 118b, the ends are connected to opposite sides of an optional watch housing 112, which contains a mechanical watch movement. Here mechanical means a watch movement which derives its power from a coiled spring and/or one which derives regulation from an escapement mechanism, rather than, for example, a quartz movement, although other mechanisms may be used instead. The watch housing 112 is made of metal such that it is hard wearing and non-brittle. In some embodiments, the metal may be a precious metal such as gold or platinum. The components of the mechanical watch movement are also made from metal. However, metals, especially precious metals, are generally radio opaque, meaning that communicating with a vehicle via radio antenna within the wearable device housing is not possible, this issue is particularly pronounced when the watch movement is a mechanical watch movement which has all metal parts.

The strap 102 is at least partially flexible and the length variable/settable, such that the wearable device 100 may be worn by users having different sized wrists. In the illustrated embodiment, this is achieved by forming part of each strap from a flexible rubber material. However, the skilled person will understand that other flexible materials could be used in other embodiments.

The strap 102 in the embodiment shown comprises a PCB, including flexible portions 114 and electronic components. In the example shown, the electronic components include first and second batteries 106, 108, the batteries may be coin cells. The electronic components further include a transmitter for transmitting radio signals 104 and a button 110 for activating the electronic components. Each of the electronic components is provided with a cage which has a plurality of uses both during and after manufacture. The transmitter for transmitting radio signals 104 may be a transceiver for receiving and transmitting signals. The transmitter for transmitting radio signals 104 is connected to an antenna 116. Each of the transmitter 104 and the antenna 116 may be configured to either transmit, receive or both transmit and receive signals, such as radio signals. The transmitter and antenna may be configured to receive and transmit signals of different frequencies.

The present invention allows the transmission of signals from the transmitter 104 because the strap 102 is formed from radio transparent materials. For example, the straps may be formed of rubber or polyurethane, and optionally coated with leather or another radio-transparent material.

The transmitter is arranged to transmit radio signals which communicate with a vehicle, allowing a user to passively unlock the vehicle when the watch is within a predetermined range, or actively lock and unlock the vehicle using the button 110. This may be referred to as a keyless entry system. Keyless entry systems typically work by the vehicle intermittently transmitting signals, which are received by a transceiver of the keyless entry system. Upon receipt of the signal from the vehicle, the transceiver produces a signal comprising a code which can be received by the vehicle. If a signal indicating a "correct" code is received by the vehicle, then the doors are automatically unlocked, with no further action from the user being required.

The wearable device 100 is provided with a button 110 attached to the strap 102, which button may be operable to cause a signal to be sent, which signal may cause a vehicle to start if it is sent from within the vehicle. However, it will be understood that the functionality available by pressing the button 110 will depend on the specific vehicle that the wearable device 100 is arranged to unlock and start. In some examples, the button may cause a signal to be sent that operates to unlock the vehicle from a relatively large distance away, in the manner of a conventional remote key.

A particular challenge associated with provision of Keyless Go^{™} and keyless entry functionality is that a relatively large amount of energy and a relatively high peak current is required to run the array of transceivers for these functions. Further, a large amount of energy will also need to be stored for the keyless entry functionality, because for some keyless entry systems the respective transceiver may need to be transmitting constantly (albeit at a very low power level). The present inventors have recognised that the peak current required by a keyless entry circuit may be in the region of 10mA for some keyless entry systems. Accordingly, it is necessary to provide a cell that is able to provide this peak current and store an amount of energy that allows the wearable device to function for a required length of time before the battery needs to be replaced. It is also important for the cell to be relatively compact, as package space within the wearable device is limited. A suitable cell/ battery may be a CR2032 coin cell.

Placing the batteries under the watch housing 112 may make the watch uncomfortably tall for the user. Therefore, the cells 106, 108 are placed in the strap 102. Placing the cells 106, 108 and the transceiver in the strap 102 ensures that the functionality of the strap and watch is maximised, without degrading the comfort and quality of the watch. Due to the volume required within the strap to house and pot each of the electronic components, it is not feasible to include a clasp, which would disengage the components, making it necessary to allow the strap to flex such that it can be removed from the user without damaging the internal components.

FIG. 1B shows a perspective view of the strap 102 with the button 122. The outer portion of the button 122 and LED indicator 120 and first and second sockets 124, 126 are visible from the exterior of the strap, but the other components are hidden within the strap . The watch housing which connects to the two ends of the strap 102 is not shown, in some examples, the ends of the strap or the sockets 124, 126, may connect to each other or to a clasp or buckle. In the example shown, the button 122 sits atop one of the battery cells (not shown). The button chassis includes an indicator light, in the form of an LED indicator 120. The battery cell is connected to a second battery which may be attached to a cage (not shown) which is connected to the transmitter for transmitting radio signals (Fig. 1A 104). The second battery is connected to the transmitter for transmitting radio signals (Fig. 1A 104) via the flexible PCB, and the transmitter is connected to the antenna (Fig. 1A 116) via the flexible PCB. In varying examples of the present invention, the electronic components can be arranged in any suitable order.

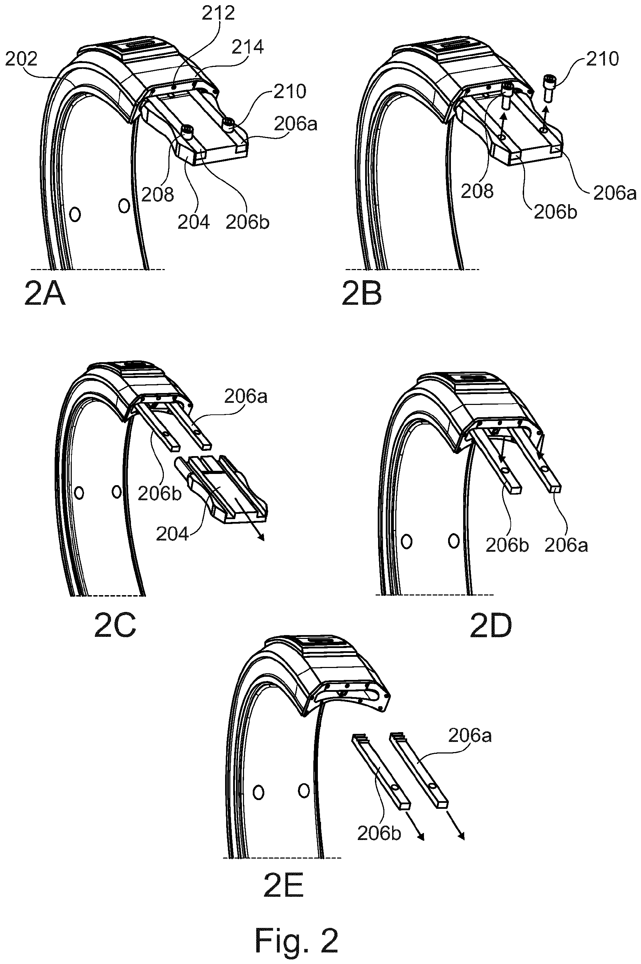

FIG. 2A shows a tool inserted into the strap 202 which may be used to arrest components within the mould prior to the injection of the wet applied structure, which may be, but not limited to polyurethane. The terms wet applied structure and polyurethane are used interchangeably in the foregoing. Additionally, the tool fills a portion of the mould which must not be filled with the wet applied structural component/ polyurethane. This portion is the interior of a socket which is used to connect the watch housing to the strap.

The tool comprises a first tool portion 204 which is releasably attached to second tool portions 206a, 206b by first tool screw 208 and second tool screw 210. The second tool portions 206a, 206b engage the interior of the socket, filling the void within and preventing the intrusion of injected polyurethane. The socket 214 may include vent holes 212, which coincide with vents within the mould and attach to a vacuum generator (not shown). The vent holes 212 extend through the socket 214 and into the void within the mould such that the air pressure within the mould can be reduced to encourage the wet applied structural component to fill the whole volume of the mould. Fibres of polyurethane may fill the vents and remain attached to the strap 202 after manufacture, these fibres can be removed with no visible trace.

When the polyurethane has cured and the mould has been removed, the tool may be partially encased in cured polyurethane, meaning that it is difficult to remove without cutting the strap. To make removal of the tool simple, it can be taken apart by removing the first and second tool screws 208, 210 as shown in FIG. 2B. The first tool portion 204 can be decoupled from the second tool portions 206a, 206b and slidingly removed from the strap 202 as shown in FIG. 2C.

The second tool portions 206a, 206b can then be detached from the socket 214 by applying a detaching force as shown in FIG. 2D and subsequently removed from the strap 202 as shown in FIG. 2E.

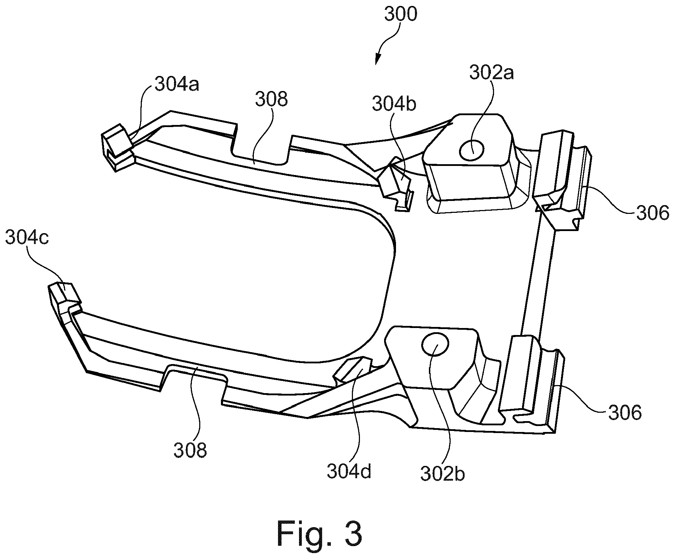

FIG. 3 shows a first cage, the cage includes an extension area 308 for accepting an electronic component (not shown), the electronic component snap fits onto snap fit receivers 304a-d such that it cannot move relative to the cage.

The cage includes holes for a fixing means 302a-b which are used to hold the cage in place during manufacture and subsequently to affix plates.

The cage includes cage pivot mount 306 which a further electronic component is mounted to, the further electronic component is held in position by a flexible portion of PCB (not shown) which provides electronic communication between the electronic component and the further electronic component (not shown).

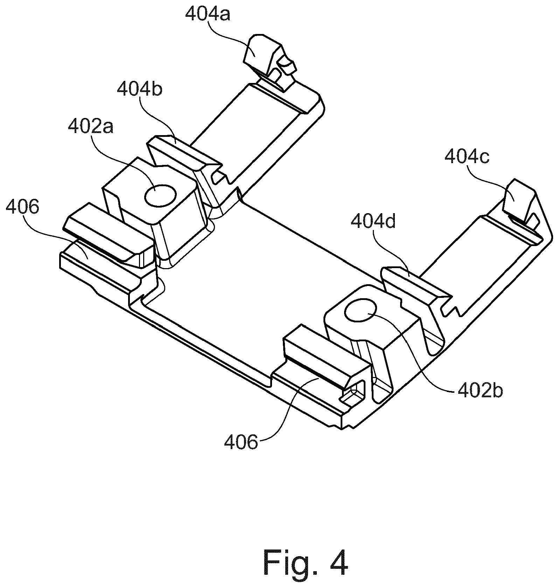

FIG. 4 shows a second cage, the second cage includes a portion for receiving an electronic component, the electronic component snap fits onto snap fit receivers 404a-d such that it cannot move relative to the cage.

The cage includes holes for a fixing means 402a-b which are used to hold the cage in place during manufacture and subsequently to affix plates.

The cage includes a cage pivot mount 406 which a further electronic component is mounted to, the further electronic component is held in position by a flexible portion of PCB (not shown) which provides electronic communication between the electronic component and the further electronic component (not shown).

In some examples, cage pivot mount 306 and cage pivot mount 406 work in conjunction to hold a single electronic component in position, such as the transceiver/ transmitter for transmitting radio signals.

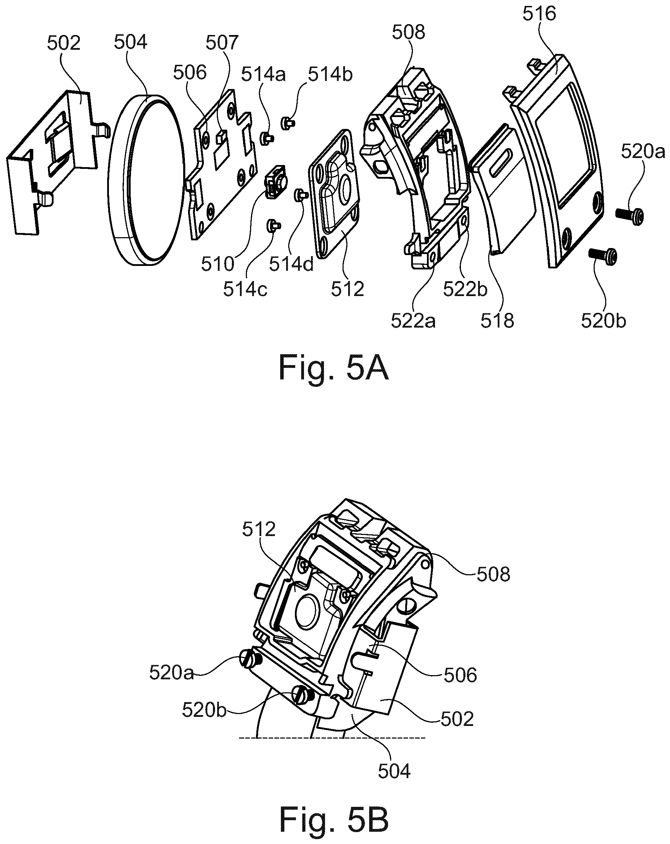

FIG. 5A shows an exploded view of the components which make up the button assembly. A clip 502 is used to hold a rigid portion of the PCB 506 to the coin cell 504. A tactile button 510 is mounted and in electrical communication with the rigid portion of the PCB 506. When depressed, the tactile button activates the circuit associated with the PCB. The button chassis 508 performs multiple tasks. It presses the perimeter of membrane 512 against the smooth surface of PCB 506 forming a fluid tight seal and it provides fixings for socket component 124 and faceplate 516 and during moulding for a cover plate. Additionally, and with reference to FIG. 5B too, it provides a surface for the cover plate to seal to during moulding to manage ingress of wet fluid into cavity around membrane. It will be appreciated that if the transparent membrane were to have an opaque layer of wet applied structural component covering it, no light would be visible from the LED, hence the need for a means to prevent ingress. In addition it can be preferred that no further wet applied component covers the button 510 as it could deteriorate the user's tactile impression of the button when pressed. One method of sealing the cavity above the membrane is to have a boundary wall with a planar surface against which a flat cover plate can be pressed. The same effect is achieved in the examples in Fig 5A and Fig 5B using a fixed radius surface, clamped to which (during moulding) is a cover plate sharing the same fixed radius surface. This cover plate also performs the function (during moulding) of forming the correct `hook' and rebate features required for the decorative faceplate 516. This way the interface to the faceplate 516 is seamless, and the two threaded holes for its fixation are blocked from being filled with wet applied structural component. It will be appreciated that surface forms other than planar or radiuses would achieve the same sealing effect. It will also be appreciated that some of the same masking effects could be achieved by pressing the perimeter wall or indeed the surface of the membrane against the outer wall of the cavity of the mould. However, this method would not prevent ingress of the wet applied structural component into the threaded holes 522a, 522b or the features required for hooking the face plate into position. When the components are assembled, the membrane 512 is situated between the rigid portion of the PCB 506 and the button chassis 508.

To provide a fluid tight seal, the membrane 512 is compressed, abutting the rigid portion of the PCB 506. The compression is achieved by clamping the button chassis 508 to the clip 502 or other suitable component and adding a fixing means to holes on the rigid portion of the PCB which hold the button chassis 508 in position, compressing the membrane 512 over and around the tactile button 510 and to the rigid portion of the PCB 506. The holes in the rigid portion of the PCB 506 may be blind holes in order to prevent short circuits. The fixing means 514a-d may be screws, rivets or pins. In the example shown solder pins are used to attach the button chassis 508 to the blind holes on the rigid portion of the PCB. A further fixing is achieved by soldering the pin 514a-d to the chassis 508, thus maintaining compression on membrane 512. After the fixing means has been applied the clamp can be removed. The button 518 is attached to the button chassis 508 using a face plate 516 which is held in position by screws 520a-b.

Organising the components in this manner means that the components within the resulting strap will be potted by the wet applied structural component, whilst the tactile button and the LED 507 is encased by the relatively flexible membrane 512, such that the wet applied structural component does not penetrate the membrane, allowing the button to be depressed.

FIG. 5B shows the assembled components of FIG. 5A, without the face plate 516 or the button 518. The clip 502 attaches to the rigid portion of the PCB 506 by way of arms on either side of the clip 502 which compliment grooves on the rigid portion of the PCB. The skilled person will understand that there are many ways to achieve this connection. The clip holds the coin cell in position behind the PCB 506. The membrane 512 is compressed in position between the button chassis 508 and the PCB 506.

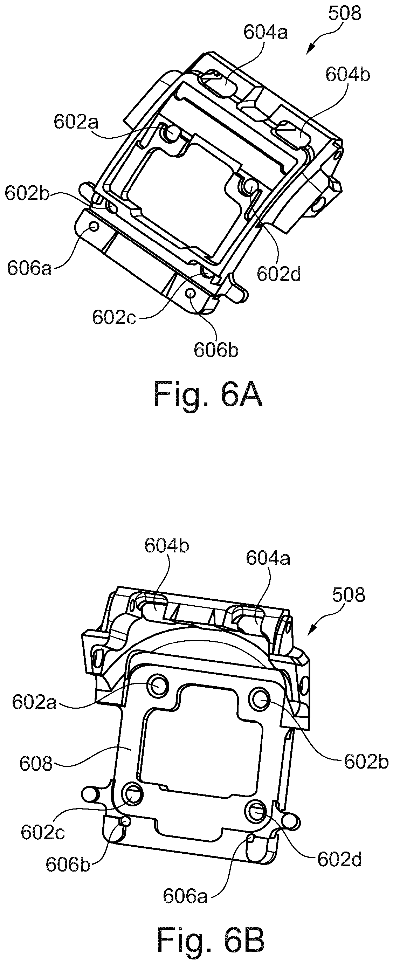

FIG. 6A shows a front view of the button chassis 508. The button chassis serves multiple purposes. First, it compresses the perimeter of the membrane against a smooth surface of PCB in order to form a fluid tight seal. Second, the button chassis provides fixings holes 606a, 606b for securing the decorative faceplate 516 in position over the button chassis. Additionally, during moulding the button chassis provides anchor points 604a, 604b for a cover plate, the cover plate covers the substantially flat surface of the chassis, to seal during moulding to manage ingress of wet fluid into cavity around the membrane. Additionally, pin holes 602a-d are provided in the button chassis. These pin holes attach to the pins, for example by being soldered into position. The pins maintain compression of the membrane between the button chassis 508 and the PCB 506.

FIG. 6B shows a rear view of the button chassis 508. The rear side provides a substantially flat surface 608 which approximately matches a face of the membrane. When assembled the membrane is compressed against the flat surface 608, such that the area encapsulated by the membrane is resistant to fluid ingress, in particular the ingress of wet applied structural component during moulding. In the example shown, the pin holes 602a-d and fixing holes 606a-b and anchor points 604a-b are thru holes. In other examples, the fixing holes 606a-b may be blind holes and the anchor points 604a-b may not be thru holes, but may instead match the anchor features.

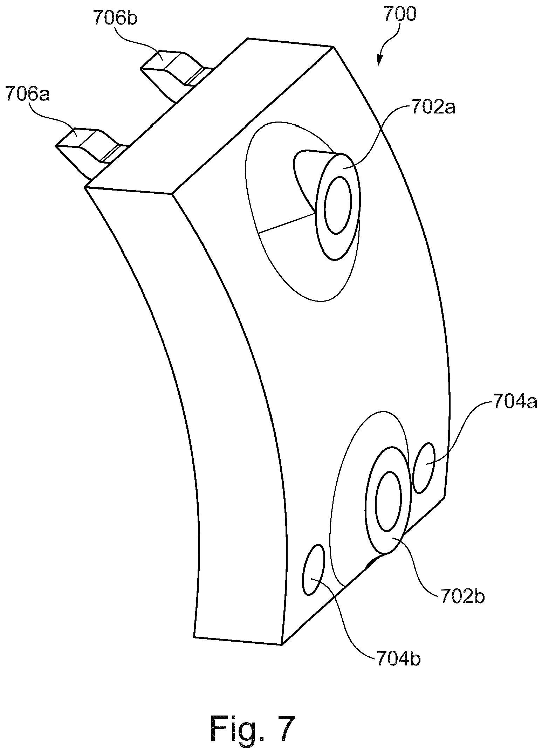

FIG. 7 shows a cover plate 700 which attaches to the button chassis 508 during moulding. The anchor features 706a-b match the anchor points 604a-b of the button chassis. Additionally, thru holes 704a-b can be used to apply fixing means to attach the cover plate to the button chassis. Attaching the cover plate 700 over the button chassis prevents ingress of the wet applied structural component within the button chassis. Tool holes 702a, 702b can be used to manipulate the cover plate into the correct position.

The following numbered list are clauses which are not to be confused with the claims:
1. A method of fully encapsulating electronics within a strap comprising:
   providing a mould for a strap, the mould comprising a first opening and a second opening,
   providing a printed circuit board (PCB), comprising at least one electronic component,
   applying a membrane to said electronic component,
   attaching a chassis to said PCB at said electronic component such that said membrane is sealed against said electronic component;
   injecting a wet applied structural component into said mould.
2. The method of clause 1 wherein the wet applied structural component is prevented from entering the area around and above the membrane by a capped off perimeter.
3. The method of clause 1 wherein said electronic component comprises a plurality of blind holes, and wherein the method further comprises soldering pins to said blind holes.
4. The method of clause 3 wherein said chassis comprises pin holes and the chassis is attached to said PCB by inserting said pins into said pin holes, applying a force to the chassis to compress said membrane and attaching the pins to the chassis.
5. The method of clause 4 wherein the pins are attached to the chassis by soldering.
6. The method of any one of clauses 1 to 5 wherein said chassis is attached to said electronic component by a band under tension.
7. The method of any one of clauses 1 to 6 wherein the thickness of the strap is less than 10 millimetres.
8. The method of any one of clauses 1 to 7 wherein the strap comprises polyurethane.
9. The method of any one of clauses 1 to 8 wherein the membrane is formed of silicone.
10. The method of any one of clauses 1 to 9 wherein the membrane is transparent for light in the visible spectrum.
11. The method of any one of clauses 1 to 10 wherein a further electronic component is attached to said chassis, the further electronic component comprising a button.
12. The method of clause 11 wherein the further electronic component comprises an LED indicator.
13. The method of any one of clauses 1 to 12 wherein the strap comprises at least one of a battery and a transmitter for transmitting radio signals, which is in electrical communication with said electronic component and/ or said further electronic component.
14. The method of any one of clauses 1 to 13 wherein the mould comprises silicone.
15. The method of any one of clauses 1 to 14 wherein the first component is arrested by a tool, inserted into said mould.
16. The method of any one of clauses 1 to 15 wherein the mould comprises vents, said vents in fluid communication with a vacuum generator for lowering the air pressure within said mould.
17. The method of any one of clauses 1 to 16 wherein the strap is attachable to a watch housing.
18. The method of any one of clauses 4 to 17 wherein said membrane comprises holes coincident or concentric to each of said pins.
19. A wearable device made according to the method of any preceding clause.

## Claims

1. A strap for a wearable device, comprising:
a printed circuit board (PCB) on which is mounted electronic components including a transmitter for transmitting radio signals and a button in electrical communication with said transmitter,
a chassis attached to said button,
a depressible button interface mounted on said chassis,
a membrane providing a waterproof seal for said button,
wherein when said depressible button interface is pressed, said waterproof seal deforms and actuates said button.

2. The strap of claim 1 further comprising at least one battery located within said strap and in electronic communication with said PCB.

3. The wearable device of claim 2 wherein said battery is a coin cell.

4. The wearable device of any one of claims 1 to 3 wherein said strap comprises polyurethane.

5. The wearable device of any one of claims 1 to 4 wherein the strap comprises a watch housing.

6. The wearable device of any one of claims 1 to 5 wherein said waterproof layer is formed of silicone.

7. The wearable device of any one of claims 1 to 6 wherein said waterproof seal is compressed between said button and said chassis.

8. The wearable device of any one of claims 1 to 7 wherein said chassis is attached to said PCB by a plurality of pins.
